# EUROPEAN PATENT APPLICATION

(11) **EP 1 699 101 A1**
(43) Date of publication of application: **06.09.2006**
(21) Application number: 05003167.3
(22) Date of filing: 15.02.2005
(51) Int. Cl.: H01M 8/04, G01R 27/02

(54) **Fast locally resolved electrochemical impedance spectroscopy in polymer electrolyte fuel cells**

(71) Applicant: PAUL SCHERRER INSTITUT, 5232 Villigen PSI (CH)
(72) Inventor: The designation of the inventor has not yet been filed
(74) Representative: Fischer, Michael

(57) **Abstract**

A system for performing locally resolved electrochemical impedance spectroscopy in a segmented Polymer Electrolyte Fuel Cell (PEFC) has been developed. The impedance measurement is carried out for all segments in parallel. Due to this unique fast parallel approach the measurement period for obtaining a locally resolved impedance spectrum is virtually independent of the number of segments used.

The current density distribution and the corresponding locally resolved impedance spectra for a PEFC segmented along a serpentine cathode flow field and operated on pure H₂/O₂ and H₂/air are presented and discussed. For low humidity H₂/O₂ operation the locally resolved impedance spectra clearly show that the performance loss along the channels can be attributed to drying effects.

For H₂/air operation the lower frequency loops of the local impedance spectra increase in size as a function of channel length. The increase becomes more pronounced with decreasing air stoichiometry. This is likely due to cumulative flooding of the GDL and a decreasing molar fraction of oxygen in the cathodic gas stream.

The locally resolved impedance spectra show that large differences in local cell impedance can occur, i.e. the impedance spectrum of the entire cell is of limited value in highlighting factors limiting cell performance and can be misleading.

## Description

### 1. Introduction

The overall performance of a polymer electrolyte fuel cell (PEFC) depends on several factors: i) operating conditions, e.g. gas stoichiometry, temperature, humidification, operating pressure; ii) applied materials, e.g. type of membrane, catalysts, gas diffusion media (GDL) and iii) cell design, e.g. flow field design and orientation of the cell.

There is only limited insight into the influence of these factors, if we form our opinion only by the measurement of the overall cell performance or by the application of diagnostic tools, like impedance spectroscopy (EIS) to the entire cell, since the active electrode area of PEFCs can exceed values of several tens of square centimetres for laboratory cells or even several hundreds of square centimetres for cells of technical scale. Inhomogeneities in the local operating conditions due to variations in relative humidity, reactant concentration, temperature gradients, edge and mass transport effects or even manufacturing inconsistencies are highly likely to occur. This results in non-uniform performance over the active area.

When measuring over the entire active area of a PEFC, only average properties of cell parameters like current density or cell impedance can be determined. Thus it is neither possible to identify inhomogeneities in fuel cell performance nor to get reliable information about limiting processes affecting cell performance. Measurements performed over the entire active area of a PEFC are only meaningful if the local operating conditions are virtually homogenous throughout the cell, e.g. when using so called 1-dimensional cells.

Thus spatially resolved *in situ* diagnostic methods for PEFCs are badly needed not only for measuring but particularly for explaining inhomogeneities in cell performance. The application of these methods to an operating PEFC will provide more reliable and more meaningful data about the impact of factors like operating conditions or cell design on cell performance and the respective limiting processes.

Locally resolved current measurements in PEFCs can highlight inhomogeneities in the current distribution. However, by the application of locally resolved current measurements one can only identify but not explain local inhomogeneities in the performance of PEFCs. More advanced locally resolved diagnostic methods are needed to get information about the respective locally limiting processes and to gain a deeper understanding how operational parameters influence cell performance.

There are three main processes limiting the performance of a PEFC, i.e. charge transfer, diffusion and ohmic resistance. The influence of these parameters on cell performance is highly dependent on the local operating conditions.

In principle Electrochemical Impedance Spectroscopy (EIS) can provide values for membrane resistance and charge transfer resistance as well as information about mass transport limitations. EIS is a powerful tool for *in situ* diagnostics in polymer electrolyte fuel cells. Thus impedance spectroscopy has been applied to the entire cell before to get more insight about processes limiting cell performance.

But what information do we get from the impedance spectrum of the entire cell, since current density distribution measurements in PEFCs clearly show that inhomogeneities in local cell performance and thus in local cell impedance are highly likely to occur.

We have addressed this question by using EIS in a segmented realistic PEFC. By doing this, locally resolved EIS measurements are possible and limiting processes affecting the lateral current distribution can be identified. In fact, each locally resolved EIS measurement comprises also the measurement of the current distribution, which can be extracted from the dc part of the segment currents.

The main barrier to apply impedance spectroscopy in PEFCs in a locally resolved approach is measurement time. Time is a critical factor in EIS, since the cell can drift or a sudden change in the state of the cell can occur, i.e. at a given cell current (galvanostatic mode) or a given cell voltage (potentiostatic mode) the current density distribution can change. Depending on the frequency range the measurement of only one impedance spectrum can consume around half an hour of time. Thus if the measurement of the segment impedances is performed one after another the measurement time rapidly increases in this serial approach with the spatial resolution, i.e. with the number of segments employed in a segmented PEFC.

No local impedance measurements in realistic PEFCs of technical relevance and under realistic operating conditions have been reported so far. Furthermore, all setups for locally resolved EIS in PEFCs are suffering from long recording times, due to serial operation.

We have addressed these drawbacks. Thus we have designed a system for performing the impedance measurement for all segments of a segmented PEFC in parallel. With our unique parallel approach for locally resolved EIS in PEFCs described here, the recording time to obtain a locally resolved EIS spectrum is dramatically reduced and becomes comparable to the time required to obtain an integral EIS spectrum. The duration of a measurement is virtually independent on the spatial resolution, i.e. on the number of segments used in a segmented PEFC. In addition, our aim was to perform locally resolved EIS in realistic PEFCs, instead of using idealized cells. We are using a 29.2 cm² PEFC with serpentine flow field, similar to our ordinary laboratory cells operated on pure H₂/O₂ and H₂/Air. Due to the open architecture of our system the setup can be easily matched to larger cells even of technical size.

The fast parallel method for locally resolved EIS in PEFCs described in this paper will help to gain a deeper understanding of fuel cell operation on a local scale and can provide the detailed information needed for validating computational fuel cell modeling results.

### 2. System for Fast Parallel Locally Resolved EIS in PEFCs

The system for performing fast locally resolved EIS in PEFCs described here, was developed and built up at Paul Scherrer institut In the current configuration the system is able to handle cell currents of up to 60A and modulation frequencies from some microhertz up to 10 KHz, but these capabilities can be expanded. With our unique approach, the impedance measurement is performed for all segments of a segmented PEFC in parallel, resulting in a radical reduction in the overall measurement time needed for obtaining a locally resolved impedance spectrum.

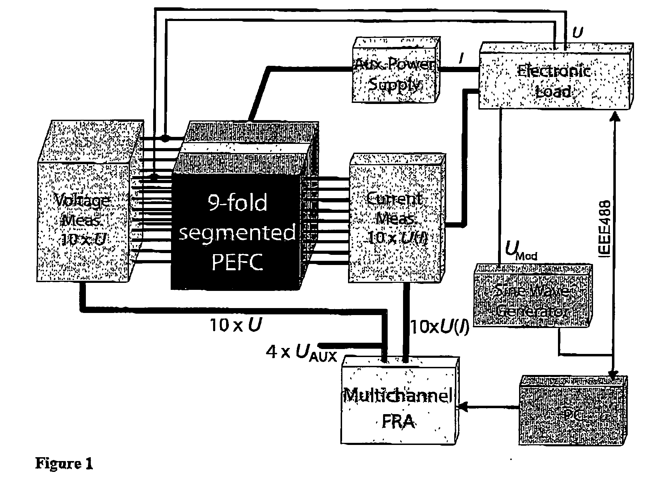

The system for performing locally resolved impedance spectroscopy is shown in a simplified block diagram in figure 1. The segmented cell is connected to an electronic load in series with an auxiliary power supply. The electronic load controls the dc and the ac current of the PEFC. The modulation amplitude and frequency is determined by a programmable sine wave generator.

The segment currents and segment voltages are measured simultaneously. For the locally resolved impedance measurement to be performed the analog current and voltage signals are fed to a multichannel frequency response analyzer, developed and built up at PSI. The system is controlled by a Personal Computer with special software.

### Segmented Cell

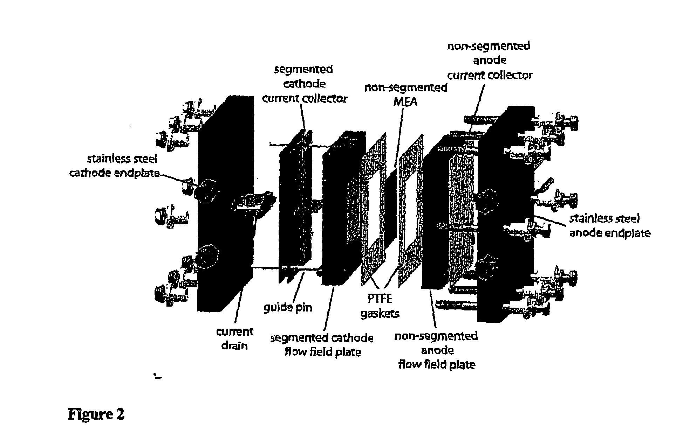

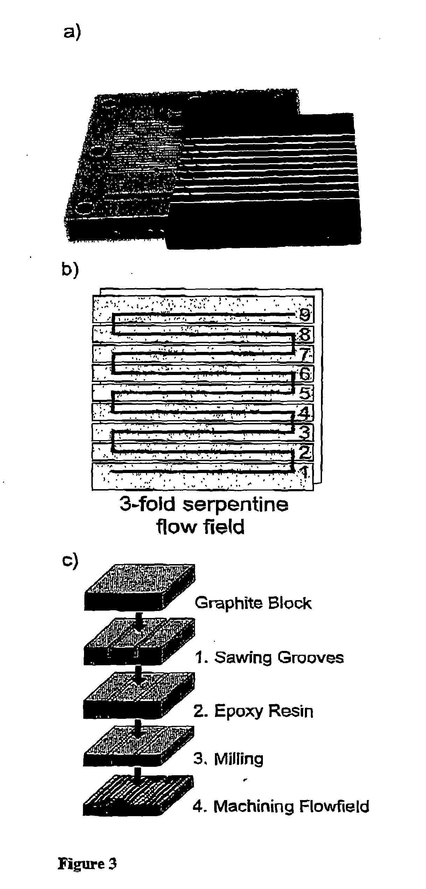

Our segmented cell (area 29.2 cm²) shown in figure 2 is similar to an ordinary filter-press type H₂/O₂-PEFC consisting of a membrane electrode assembly (MEA) sandwiched between two 3-fold serpentine flow field plates, which are clamped together by outer stainless steel end plates. The only exception is the cathode flow field plate and its gold plated current collector. Both are divided into 11 electrically isolated segments (figure 3a), i.e. the cathode flow field is 9-fold segmented. Since the cell is segmented along the gas channels (figure 3b), it is possible to measure the variation of current density and impedance with changing reactant and water concentration along the gas channels. The manufacturing process of the segmented cathode flow field plate is schematically shown in figure 3c. Nine grooves of 0.4 mm width and 16 mm depth are sawed into a compact graphite block (Diabon NS 2, SGL Carbon Group, Meitingen, Germany) of 20 mm thickness. The graphite block is then heated up to a temperature of 110 °C and the grooves are filled with a low viscosity epoxy resin at this temperature. The curing is done at 100°C for 4 h. After curing of the resin the remaining compact part of the graphite is milled away, resulting in a segmented graphite plate with an overall thickness of 15 mm and outer dimensions of 100 mm x 100 mm.

Both sides of the segmented graphite plate are polished. This is of prime importance to minimize contact resistances between the segments of the graphite plate and the cathode current collector. After this the 3-fold serpentine flow field with a channel width of 1 mm (channel to land ratio 1:1) and a channel depth of 0.5 mm is machined along the segments. Each segment is equipped with a socket for voltage and temperature measurement.

Two guide pillars made from PEEK are used to enforce the compression strength of the segmented plate. The anode flow field plate is of identical type with the exception of segmentation using the same flow field pattern. A non segmented gold plated copper plate serves as the anode current collector (figure 2).

The segmented current collector consists of a fiber-glass reinforced epoxy plate and 11 gold plated copper plates which are sticked on this plate (figure 2). The gold plated copper plates are electrically isolated of each other. Each of the inner 9 plates collects the current of one active segment, whereas the outer 2 larger plates exclusively serve as spacer between the epoxy plate and graphite flow field plate, but do not carry any current (figure 2, 3). The inner 9 segments are equipped with a drill to screw on the current collector to the current drain. The current drain is made of 9 gold plated copper rods inserted into an insulator. The copper rods are equipped with a thread on each top for connecting the cathode current collector on the one and the current measuring circuitry on the other side. The endplates are equipped with cut-outs for taking up the insulator.

All parts of the cell are assembled by using guide pins. The MEA is sandwiched between the non-segmented anode and the segmented cathode flow field plate (fig. 2).

The GDL of the MEA is not segmented, so lateral currents across the GDL are allowed to occur as it happens in non segmented PEFCs, too. However, potential differences between the segments have to be kept as low as possible to minimize lateral currents through the GDL. Special arrangements have to be made for this problem as described in this paper.

### Current and voltage Measurement

The basic requirement for an impedance measurement to be performed properly is the accurate measurement of the voltage and the respective current signals. Furthermore connecting the voltage and current measuring circuits to the cell should not have any impact on the measured parameters themselves.

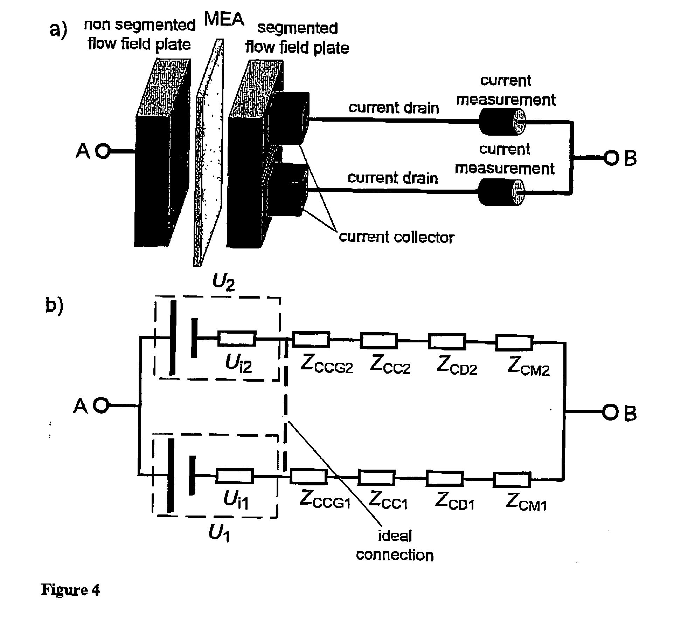

In principle a segmented PEFC is a parallel circuit of individual sub-cells as shown schematically for a two-fold segmented cell in figure 4a. However, these sub-cells, represented as voltage sources *U*₁, *U*_{*2*} in the equivalent circuit (fig. 4b) are not ideally connected as it would be the case in a non segmented cell. In series to each sub-cell is the impedance of the current collector plate *Z*_{CC}, the impedance of the contact between current collector plate and graphite segment *Z*_{CCG}, the impedance of the current drain *Z*_{CD} and the impedance of the current measuring circuitry *Z*_{CM}. Due to these series impedances the segment voltages can be different in phase and amplitude when operating the cell in galvanostatic mode. In this parallel circuit the voltage is equal in phase and amplitude only between point A and B, Thus for the locally resolved impedance measurement to be performed properly it is desirable to measure all segment voltages individually. Since the current is constant in phase and amplitude in each branch of the parallel circuit, each segment impedance can be calculated from the respective ac segment voltage and the respective ac branch current

Wide bandwidth differential electrometers are used for the measurement of the segment voltages. The segments are connected to these amplifiers by using twisted pair wires. The small offset voltages of the amplifiers are estimated with the inputs being connected to ground. The result of the calibration measurement can be stored to correct for dc errors in segment voltages. Due to the high input impedance of the differential electrometers, the cell operation is not influenced by connecting these amplifiers to the segments.

However, any series resistance to *U*_{*x*} (*x*=1, 2) has an impact on the current density distribution, even if all series resistances are of equal size. Differences in the segment currents lead to potential differences between the segments and lateral currents across the gas diffusion layer can result. The only way to circumvent this problem is an ideal individual potentiostatic control of each segment voltage. The potentiostatic control circuit compensates for any voltage drop between B_{*x*}' (*x*=1, 2) and B. However, this approach is costly and furthermore, commercial multichannel potentiostats are not ideal, errors in the regulated cell voltage can occur. Evenmore, galvanostatic operation of a fuel cell is more realistic than potentiostatic operation.

Considering these drawbacks it is reasonable to operate the segmented cell in galvanostatic mode accepting small differences in voltage between two adjacent segments. In gatvanostatic operation mode only one electronic load is necessary to control the ac and the dc current of the segmented PEFC. Even potentiostatic control is possible with employing only one load and might be advantageous when performing impedance measurements near the limiting current region, In this operation mode the voltage of only one segment is controlled, i.e. the load keeps the cell current at a level where the branch current through this segment is adequate to keep the segment voltage constant.

However, in this approach all resistances between B_{*x*}' (*x* = 1,2) and B (fig. 4) have to be minimized to a level near zero. Especially the measurement of the segment currents becomes challenging in this context, since employing current measuring resistors for this purpose is highly unfavorable.

A zero resistance ammeter (ZRA) is needed for this task, i.e. a current to voltage converter that produces a voltage output proportional to the current flowing to the input terminals while imposing a 'zero' voltage drop to the external circuit. We took into consideration two possibilities to realize the ZRA circuits for the measurement of the segment currents.

The first one is the application of current follower circuits. One current follower has to be built up for each segment. With this approach the potential of the segments is kept constant, i.e. it is kept at "virtual ground" with the anode segmented. In an ideal circuit, no voltage gradients between the segments can occur. However, this technique is complex since amplifiers are employed and each current follower has to drive the whole segment current. So this approach is impractical for cells of technical scale exhibiting cell areas of several hundreds of square centimetres. Even with our segmented laboratory cell the segment currents can easily reach values of several Amps. Furthermore, due to the large dimension of the circuits it is difficult to connect the current followers directly to the drain of the current collector. Since wires are needed for this purpose, this will again increase the impedance between B and B_{*x*}' *(x* = 1,2),

The second solution to realize an ZRA is the utilization of Hall effect current sensors.

Hall effect current sensors measure the magnetic field strength in close proximity to the current conductor. A magnetic field passing through a semiconductor resistor will generate a differential voltage proportional to the field, i.e. in theory no additional voltage drop will occur due to the measurement of the segment currents. There are two techniques for sensing current using Hall effect devices.

In an open loop topology, the Hall element output is simply amplified and the output is read as a voltage that represents the measured current by a scaling factor. In order to induce a larger signal out of the Hall element, the current conductor may be wrapped around a slotted ferrous toroid. In a closed loop topology, the output of the Hall element drives a secondary coil that will generate a magnetic field to cancel the primary current field. The secondary current, scaled proportional to the primary current by the secondary coil ratio, can then be measured as voltage across a sense resistor. By keeping the resultant field at zero, the errors associated with open loop sensors, i.e. offset drift, sensitivity drift and saturation of the magnetic core will be effectively canceled. Closed-loop Hall effect current sensors do not only provide excellent accuracy but particularly provide the fast response time and wide bandwidth needed for performing impedance measurements in PEFCs. We have tested a variety of dosed loop sensors. Currently we are using current sensors of LEM Switzerland (LAH 25-NP), the design of these devices internalizes the current carrying conductor, i.e. the sensor has to be connected in series to the current drain of a segment and introduces a small series impedance. The impedance of the sensor is very small and depends on the selected conversion ratio (180 µΩ, 12nH @ 1:1000 and 810 □□. 54 nH @ 2:1000). For the impedance measurements shown here a conversion ratio of 2:1000 was chosen. In this configuration the overall series resistance between B_{*x*}' (*x=* 1, 2) and B is around 1.5 m□ including all contact and wire resistances. The measuring resistance for the secondary current was chosen for a sensitivity of 0.7 V/A and a maximum segment current of 7 A, limited by the input range of the data acquisition system. Even when strong current gradients in the cell occur (e.g. H₂/O₂-operation in co-flow mode under low humidity conditions) the difference in current between two adjacent segments will not exceed values of around 2 A, i.e, even under extreme conditions the maximum potential difference between two adjacent segments will not exceed a value around 3 mV.

The main advantage is the high flexibility of this approach using only one load and closed loop Hall sensors. The load and the current measuring circuitry can be easily adapted to larger cells keeping all the other components of the setup unchanged, since a variety of appropriate electronic load modules and closed loop Hall sensors are available. Since the impedance of the Hall sensors decreases with increasing current capability and decreasing sensitivity larger segment currents will not necessarily lead to a proportional higher voltage drop over the sensors.

Due to the compact dimensions of the Hall sensor circuits it is possible to mount them on a specialty designed printed circuit board which is directly connected to the current drain of the current collector to keep the overall impedance of the current measuring circuit as low as possible. The cell is operated at temperatures around 80°C and in principle, the sensors employed here can operate up to temperatures of 100°C. Due to the closed loop design the temperature drift of the sensors is low and small changes due to changing room temperature can be accepted. However, the dc and ac error slightly increase at elevated temperature. In order to avoid a calibration of the sensors as a function of temperature, they are kept at room temperature by using a simple fan. However, even at room temperature the bandwidth of the Hall sensors is limited (200 kHz @ -1 dB) which results in a small error of a few percent in measured impedance at higher frequencies, i.e. above 1 kHz. Since our goal was to perform locally resolved impedance measurements up to frequencies of 10 kHz, though our multichannel FRA is able to handle modulation frequencies up to more than 60 kHz, we had to correct for this. Calibration was done for each individual channel by using a dummy cell made from nine low inductance resistors. The error in measured impedance introduced by the current sensors was measured as a function of frequency by using this dummy cell. Scaling functions were determined for each channel. Furthermore, the offset voltages of the Hall sensors are estimated with the cell being disconnected from the load. The result of the calibration measurement is stored to correct dc errors of each channel.

### Control ofAC and DC Current

Our aim was to set up a system for performing locally resolved EIS in realistic PEFCs of different scale, i.e. in small laboratory cells and in cells of technical scale as well. So a highly flexible system architecture was chosen employing only one electronic load for controlling the dc and the ac cell current of the cell. Segment currents up to 100A can be measured by employing different types of closed loop Hall sensors in the current measuring circuitry. A variety of programmable wide bandwidth electronic loads is commeroially available. The system can be easily customized for cells of different size by employing appropriate electronic loads and current sensors, while keeping the rest of the setup unchanged.

For the locally resolved EIS measurements shown here, we have been using a popular N3300A series load (N3304A Agilent Technologies) providing two current ranges of 6A and 60 A. Load modules are available within this series with current capabilities up to 120 A and a bandwidth of 10 kHz @ -3 dB.

The dc current of the load is programmed via IEEE488 interface, whereas the ac current is controlled via the external modulation input of the load. A programmable function generator (33220A Agilent Technologies), controlled via IEEE488 interface, is employed for providing the sinusoidal control voltage for the external modulation input.

However, due to the limited bandwidth of the load (10 kHz@ -3 dB) an attenuation of the modulation current at a given control voltage level occurs at higher frequencies. This does not have any effect on the impedance measurement to be performed properly, as long as the level of the ac signals is high enough to be measured. The voltage and current measurement is performed by the external circuits of the system and thus is independent from the characteristic of the respective electronic load. However, the amplitude of the function generator signal can be increased at higher frequencies, to keep the modulation current amplitude constant. Due to the high sensitivity of the multichannel frequency response analyzer built up for performing the locally resolved impedance measurement this is not done in practice.

### Multichannel Frequency Response Analyzer

For both, data acquisition and frequency response analysis as well, a multichannel frequency response analyzer has been built up. This analyzer has 10 voltage and 10 current channels and can perform the frequency response analysis at a given modulation frequency for up to 9 segments and the entire cell in parallel. Measurement of the entire cell spectrum is not performed to date. Furthermore, there are 4 secondary voltage channels to employ reference electrodes in segmented PEFCs. This unique parallel approach leads to a radical reduction in measurement time for obtaining a locally resolved impedance spectrum.

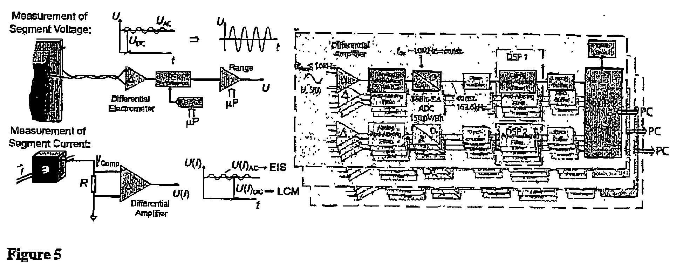

The architecture of the voltage and current channels is shown in figure 5 in a block diagram. During normal dc operation of the cell these channels are used for simultaneous sampling of the dc segment voltage and segment current signals up to a maximum sampling rate of approximately 150 kHz for each channel. Locally resolved transient analysis of PEFCs and fast pulse or step experiments or even locally resolved time domain EIS in PEFCs are possible with these high performance data acquisition channels and planned for future work.

When performing impedance spectroscopy the segment voltages and currents have a small ac and a large dc part The small ac signals have to be amplified to provide a high resolution measurement of the cell impedance. For this, the large dc parts of the signals have to be suppressed. A voltage equal to the dc signal but with inverse sign is added to the signal before amplification. This is done for the moment only for the voltage signals by using individual adder circuits for each voltage channel. Since all segment voltages have virtually the same dc part only one programmable voltage source is needed to provide the suppression signal. A high precision 12 bit digital-to-analog converter is employed for this purpose.

A dc voltage suppression circuit for the current channels is intended but complex and not realized to date since an individual voltage source is needed for each current signal. For the time being the current channels provide sufficient resolution in this first approach for parallel EIS. The current channels have a fixed bipolar input range, whereas each voltage channel provides two switchable bipolar input ranges with different sensitivity. The dc voltage of the cell is determined before the impedance measurement is performed without a dc suppression voltage applied as a mean value of all segment voltages by using the low sensitivity input range of the voltage channels. The impedance measurement is then performed by using the high sensitivity input range with the dc suppression voltage applied. Due to the limited resolution of the digital-to-analog converter and small differences in the segment voltages, there is always some misalignment between the actual dc voltage of a segment and the magnitude of the dc suppression signal. Thus the residue signal of a segment voltage, with the dc suppression voltage applied, always contains a small dc part. This dc part is determined by averaging the residue signal over an integral number of periods of the modulation signal. Due to the high precision of the digital-to-analog converters and the adder circuits the actual dc voltage of a segment can be calculated by the addition of the programmed dc suppression voltage and the dc part of the residue signal for each modulation frequency applied in a sweep, i.e. a drift of the cell voltage during the measurement of a spectrum will be detected. Evenmore, a drift of the segment currents during a frequency sweep, i.e. a change in the current density distribution can be detected. Therefore, the dc part of the current signals and thus the present current density distribution is determined for a given modulation frequency by averaging these signals over an integral number of periods of the sinusoidal modulation signal.

The current configuration provides 10 current and 14 voltage channels, but the system can be expanded. Each of the high performance data acquisition channels shown in figure 5 is equipped with a differential input stage to suppress common mode signals and fourth order analog anti-aliasing filters with fixed cutoff frequency. The signals are digitized in parallel by using 64x oversampling sigma-delta analog-to-digital converters. Thus overall 24 analog-to-digital converters are employed. All converters are clocked simultaneously with a fixed sampling rate of approximately 10 MHz. After decimation by 64 within the analog-to-digital converters, the digitized signals are output in parallel with a resolution of 16 Bit at a constant rate of approximately 150 kHz. This sampling rate is too high to be applied at lower modulation frequencies. This would result in an inflationary number of data points within one period of the sinusoidal modulation signal. Thus it is necessary to deamate the number of data points, which results in a lower effective sampling rate.

The effective sampling rate is determined by the modulation frequency and the desired number of samples to be taken in one period of the sinusoidal modulation signal. Since lowering the sampling rate results in a lower effective Nyquist frequency, programmable digital low pass filters with extremely sharp cutoff characteristics are employed to attenuate spectral components above the effective Nyquist frequency before decimation. A digital signal processor (DSP) performs fiftering and decimation of the data for each group of four channels, thus an overall number of six DSPs are employed for performing this task for all data channels. For frequency domain impedance measurements up to 10 kHz the cutoff frequency of the digital filters is chosen to be one tens of the effective sampling rate.

After decimation the data is transferred to a microprocessor via first in first out (FIFO) memories. One microprocessor is used for each group of 8 channels. The micoprocessors store the data in a RAM and allow communication with a PC.

For a given modulation frequency the data of a selectable number of periods is used for determining the impedance of the segments by using discrete fourier transform (DFT). This is done in several steps. First the dc parts of the digital voltage and current signals are estimated and subtracted from the data, since large dc parts can cover the small ac signals in the spectrum. The ac data is multiplied with a window function. Several window functions are selectable for this purpose. For the impedance measurements shown here we have been using the Van Hann window function. In a next step the windowed data is filled up with zeros to the desired number of points to be obtained in the spectrum. A large number of zeros decreases the inter frequency spacing of the fourier transformed data, i.e. the frequency and amplitude of the maxima in the spectra can be detected with higher precision. Each data set is then fed to a fast DFT algorithm to transform the data from time into frequency domain, i.e. to get the complex voltage and current as a function of frequency for all segments. All data points above the Nyquist frequency are discarded. From these spectra the amplitude spectra of the voltage and current signals are calculated. The peak amplitudes and peak frequencies in the voltage spectra are detected and evenmore, the peak values are determined in the spectra of the respective current signals for these given peak frequencies. The amplitude of the sinusoidal ac current and ac voltage signals are computed as 16 Bit values by dividing each peak value by the coherent gain of the window function and multiplication by two, since only one half of the signal energy is contained in the part of the spectra from dc to the Nyquist frequency. These numbers are converted to the respective ac voltage and ac current amplitudes taking into account the transfer function of the voltage and current channels.

The impedance for each segment at a given modulation frequency is determined as follows. The complex voltage and the complex current spectra are divided by each other. The modulus, phase, real and imaginary part of the impedance are determined at the respective peak frequency in the resulting impedance spectra, taking into account the transfer function of the voltage and current channels. The data set of each segment at a given modulation frequency is stored. Furthermore the data set of each segment is corrected for errors in modulus, phase, real and imaginary part by using the scaling functions of the calibration procedure. This procedure is done for each given frequency during the measurement, i.e. the spectrum can be displayed in real time.

Due to our unique parallel approach the duration of a measurement for obtaining a locally resolved impedance spectrum is comparable to the time required to obtain an integral impedance spectrum.

### Software

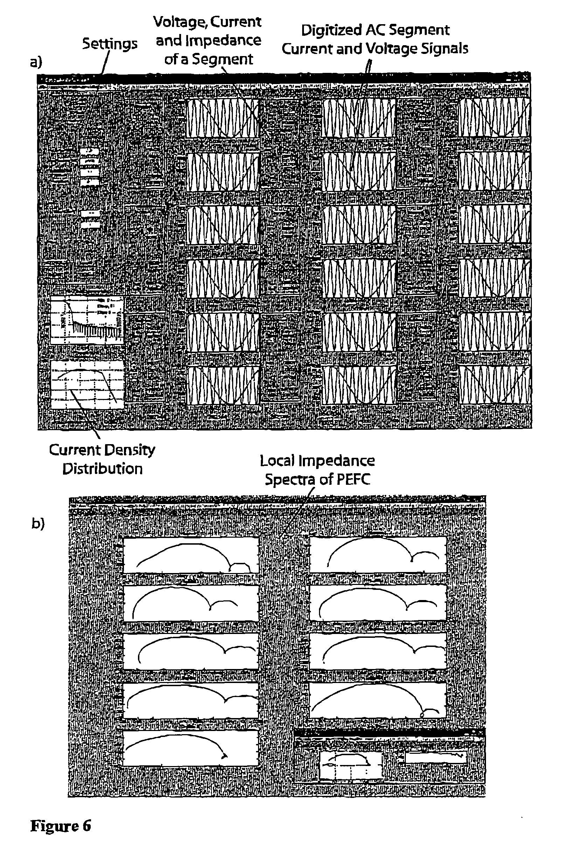

The software for controlling the system via personal computer was written in MATLAB GUI Builder (The Mathworks Inc.). The software interface to operate the impedance system is shown in figure 6.

The cell can be operated in constant current or constant voltage mode. In constant current mode the integral cell current is controlled by the load, in constant voltage mode the voltage of any segment. During normal dc operation of the cell, i.e. when an impedance measurement is not performed, all segment voltages and all segment currents are displayed as numerical value, furthermore the active current density distribution and the segment currents vs. running time are displayed in real time. Though the hardware provides much faster acquisition rates up to approximately 150 kHz, not necessary for normal operation of the cell, these values are updated only every second. All values are stored in a log file.

The cell is kept in dc operation mode until the segment voltages and the segment currents become virtually unchanged, i.e. a steady state is reached. This is a precondition for the locally resolved impedance measurement to be performed properly. However, the impedance measurement can be started or cancelled any time in this mode.

The impedance measurement can be perfomed in constant voltage or constant current mode, the amplitude of the sinusoidal modulation voltage or the modulation current can be chosen. However, with the load employed for the measurements described here only galvanostatic ac operation is possible, A frequency sweep is alternatively carried out in a linear or logarithmic sweep mode, i.e. with equally spaced measuring points on a linear or on a logarithmic scale. The respective frequency increment or the respective number of points per decade and furthermore the direction of the sweep can be chosen via the software. Evenmore settings like the number of sine waves to be taken into account for the frequency response analysis within a given frequency range or DFT settings like the window function or zero padding of the time domain data can be chosen. There are several other options included in the software, e.g. automatic detection of voltage reversal including automatic shutdown of the load and many more.

During the impedance measurement the determined ac and dc values for voltage and current at a given frequency are displayed in real time and saved in a file for each segment, Thus a drift of the segment voltages or the segment currents during the frequency sweep will be detected. Furthermore the sampled sinusoidal ac voltage and current signals are displayed for each segment as a function of time to check the quality of the time domain signals, which are 'free' of noise if the cell performs stable (figure 6a).

By this, even a drift at a given modulation frequency, i.e. during the impedance measurement, will not remain undiscovered.

For a given modulation frequency the impedance for each segment is displayed in real time during the measurement as real and imaginary part or modulus and phase of the impedance. The impedance spectra of all segments and evenmore the current density distribution is displayed in real time during the measurement altematively in Nyquist or

Bode representation (figure 6b). Corrected or uncorrected data can be displayed. To check the quality of the DFT evenmore the determined peak frequencies are displayed.

A MATLAB software has been written for easy processing the large amount of data involved with locally resolved impedance measurements.

### 3. Experimental

Membrane electrode assemblies were prepared from Nafion 115 membranes and Toray paper based Pt/C electrodes with a platinum loading of 0.66 mg/cm², The MEA was hot pressed for 3 minutes at 50 kN and 120°C. PTFE gaskets, 200 µm thick, were used to seal the cell. The fuel cell was assembled with a torque of 4 Nm per bolt.

The cell was operated at ambient pressure in galvanostatic operation mode with H₂/O₂ and H₂/air as the reactant gases using a cell temperature of *T*_{Cell} = 70°C. The dc cell current was chosen to be *I*_{Cell} = 14,6 A.

Under H₂/O₂ operation the gases were humidified at a temperature of *T*_{hum. H2} = *T*ₕᵤₘ. ₀₂ = 55°C and fed to the cell in co-flow mode using a stoichiometry of λ_{H2} = λ_{O2} = 1.5. The gases were fed to the cell by using heated pipes operated at a temperature of *T*_{plpe H2} = *T*_{pipe O2} = 70°C. For H₂/air operation the gases were fed in counter-flow mode using a stoichiometry of λH₂ = 1.5 (T_{hum H2} = 75°C, T_{pipe H2} = 80°C) and air was fed using various stoichiometries of λ_{O2} = 2.0, A_{O2}= 2.5 and λ_{O2} = 3.0 (*T*_{hum. O2} = 70°C, *T*_{plpe O2} = 80°C).

The locally resolved impedance measurements were started when the segment voltages and currents became virtually unchanged, The dc segment currents and voltages saved in a log file during the measurements were checked for a noteworthy drift and evenmore the quality of the displayed ac current and voltage signals was checked for each modulation frequency applied.

### 4. Results and discuission

### H₂/O₂ operation of the cell

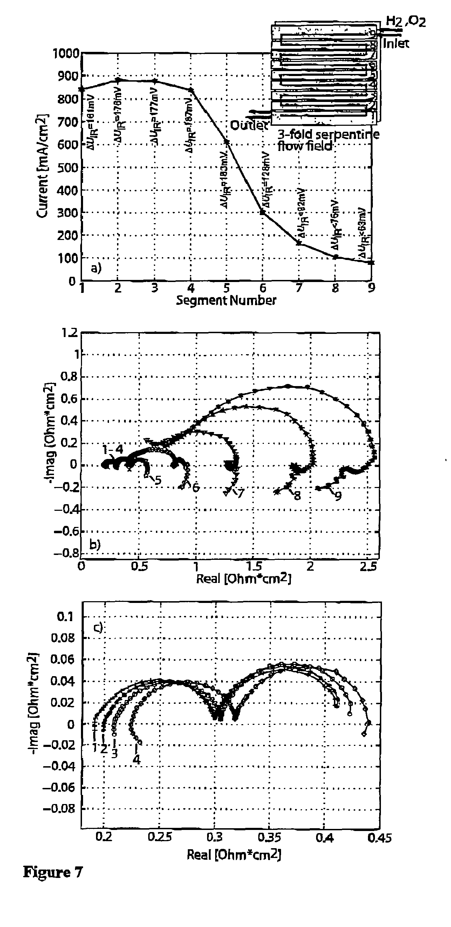

The results we obtained for the current density distribution and the respective locally resolved impedance spectrum for low humidity H₂/O₂ operation of our segmented PEFC are shown in figure 7. The results of a detailed investigation on the influence of gas humidification and gas flow direction in a segmented PEFC operated on pure H₂/O₂ are presented in another paper [26]. In the experiments described here both gases were fed to the gas inlets at the top of the cell and passed along the gas channels in co-flow mode (figure 7a).

The benefit of an increasing relative humidity due to the formation of product water along the gas channels is clearly demonstrated. As the humidity increases along the channels from segment 9 to segment 1 due to cumulative utilization of oxygen, the current density increases in principle in the same direction (figure 7a). Starting from the gas inlets at first the current density slightly increases from segment 9 to segment 6 ("low current density region") followed by a strong increase in current density (segments 6-4) until a plateau at high current densities of around 850mA/cm² is reached (segments 1-4). In this plateau region ("high current density region") the current density passes a small maximum, i.e. the current density slightly decreases towards the gas outlets.

As the current density increases along the channels the shape of the local impedance spectrum changes dramatically, i.e. the effect of processes limiting cell performance change along the channel (figure 7b).

The impedance spectra of segments 1-4 (high current density region) are all similar in shape (figure 7c). All spectra show one high frequency and a second low frequency capacitive arc. However, the ohmic resistance taken from the high frequency intercept with the real axis clearly increases along the channels from segment 1 to segment 4, clearly demonstrating the increasing membrane resistance with decreasing humidity, whereas the real axis intercept of the higher frequency arc decreases in size with decreasing humidity.

If we attribute the real axis intercept of the higher frequency loop to the charge transfer resistance the increasing size of the real axis intercept with increasing humidity from segment 4 to segment 1 might be due to cumulative blocking of active sites due to formation of liquid water. Since the ohmic resistance decreases with increasing humidity, i.e. in opposite direction to the increasing charge transfer resistance, this could explain the slight maximum in current density observed in the high current region.

However, with further decreasing humidity and current density along the gas channels towards the gas inlets from segment 4 to segment 9 a strong increase in ohmic and charge transfer resistance is observed in the local impedance spectra.

Furthermore, an additional high frequency loop becomes apparent in the spectra of segments 5-9. In the spectra of segments 7-9 the high frequency loop is still not closed at modulation frequencies of 10 kHz.

To date our measurement setup is limited to modulation frequencies up to 10 kHz. The high frequency real axis intercept in the impedance spectra of segments 7-9, i.e. the ohmic resistance of these segments, could only be estimated. For these segments the real part at a modulation frequency of 10 kHz was used to calculate an upper limit for the ohmic voltage drop □*U*_{IR} in a segment. Due to a decreasing ohmic voltage drop □*U*_{IR} along the channels from segment 5 to segment 9 and thus an increasing overall polarisation of the electrode in the same direction (figure 7a) the increase in charge transfer resistance from segment 5 to segment 9 can only be due to drying of the catalyst layers and by this loss of active area. The increasing ohmic resistance along the gas channels can be attributed to drying of the membrane with decreasing humidity.

In the low frequency range of the local impedance spectra of segments 5-9 an inductive behaviour occurs, whereas the capacitive low frequency arc withers, This capacitive arc has disappeared in the local impedance spectrum of segment 9, but two inductive loops are here clearly apparent. This evolution of the local impedance spectrum along the gas channels can be understood in a first approach by taking into account results we obtained for the anode and cathode spectrum by using a so called 1-dimensional PEFC operated on pure H₂/O₂. For this, we have been using a pseudo reference electrode incorporated into the polymer electrolyte [24]. The anode spectrum is showing three capacitive arcs and has been modeled starting from kinetic equations. The high frequency arc can be attributed to hydrogen charge transfer kinetics and the double layer capacity, the middle frequency arc to hydrogen adsorption and desorption and the low frequency arc to finite diffusion including water transport in the aqueous phase within the polymer morphology.

The cathode spectrum shows one high frequency capacitive arc and an inductive low frequency arc. The impedance spectrum of the oxygen reduction reaction on platinum nanoparticels in nation in a gas diffusion electrode with thin active layer has been modelled assuming an ECE mechanism with two adsorbed intermediate species. According to this model the capacitive loop can be attributed to the charge transfer resistance/double layer capacity and relaxation of one of the two adsorbed intermediate species. The low frequency inductive loop is explained by the second relaxation of the adsorbed intermediate species.

In our measurements employing a pseudo reference electrode the low frequency capacitive loop of the anode spectrum and the inductive loop of the cathode spectrum appear in a similar frequency range. The low frequency capacitive arc of the anode spectrum increases in size with increasing current density whereas the low frequency inductive arc of the cathode spectrum decreases, i.e. at high current densities the capacitive low frequency arc of the anode spectrum masks the inductive behaviour of the cathode. So there is a competition between the low frequency inductive arc of the cathode and the low frequency capacitive arc of the anode in their contribution to the overall impedance spectrum of the cell,

According to these results there might be two kinetic regimes in the cell. At high current densities and high humidity (segment 1 - 4) the ORR kinetics and the diffusion at the anode are rate limiting (figure 7c). At low current densities and low humidity (segment 6 - 9) the diffusion is less or rather not important, since the capacitive arc in the lower frequency range disappears and the inductive behaviour of the cathode becomes dominating (Figure 7b). Here the ORR and, due to the formation of a third higher frequency arc, possibly evenmore the HOR are strongly limiting due to drying of the catalyst layers. The ohmic and especially the charge transfer resistance increase dramatically along the channel length with decreasing humidity due to drying of the membrane and the catalyst layers (Figure 7b). However, two inductive loops are present in the spectrum of segment 9 and it is unclear, whether the lower frequency part of this spectrum can exclusively be attributed to the cathode, or whether the lower frequency part of this spectrum is still influenced by the low frequency capacitive behaviour of the anode spectrum.

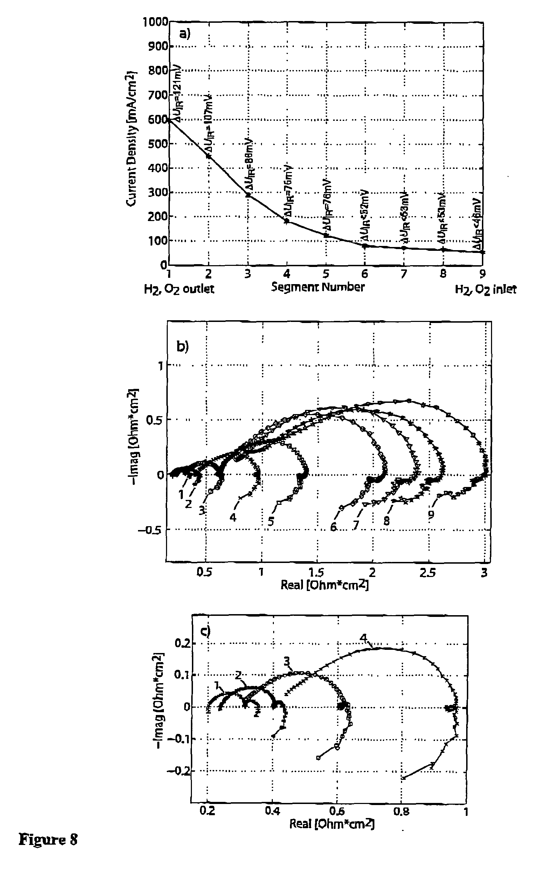

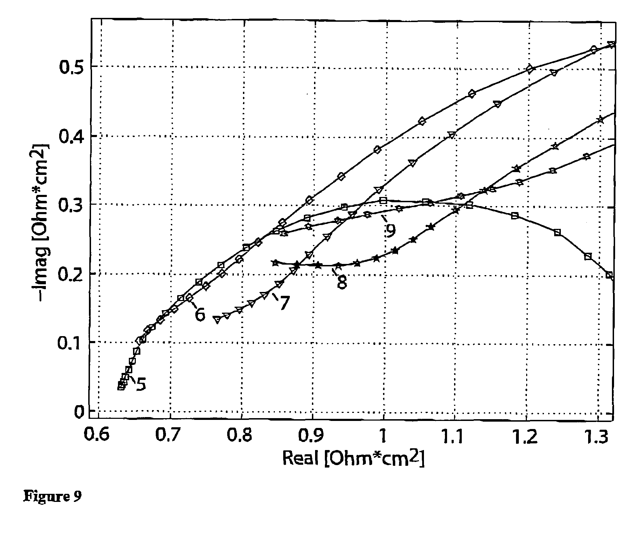

To corroborate the results, we have operated the cell at a lower overall cell current of *I*_{Cell} = 5A keeping the gas flow rate constant, i.e. the cell was operated using a gas stoichiometry for H₂ and O₂ of λ= 4,4. The results are shown in figure 8. Again the current density increases along the channels with increasing humidity, but due to the higher gas stoichiometry and the lower cell current a plateau in current density is not reached anymore (figure 8a). Starting from the gas outlet (segment 1) the charge transfer resistance and in principle the ohmic resistance dramatically increase due to cumulative drying of the catalyst layers and the membrane along the channels (figure 8b, c). Even here the capacitive lower frequency arc withers with decreasing humidity and decreasing current density (figure 8c) and finally disappears (figure 8b), whereas two inductive loops in the low frequency range of the spectra and an additional high frequency capacitive loop become clearly apparent in the local impedance spectra of segments 5 - 9 (figure 8b), The formation of the higher frequency loop is dearly seen in figure 9, the formation of the loop becomes more pronounced with decreasing humidity, i.e. with increasing segment number. However, the extrapolated value of the high frequency intercept with the real axis is comparable for segment 5 and 6 and this seems to be also true for segment 7-9.

Further investigations including identification of anode and cathode contributions to the overall segment impedance are necessary to clarify the origin of the additional higher frequency loop and the formation of the two low frequency inductive loops. For this our pseudo reference electrode concept has to be incorprated into our segmented PEFC. Furthermore, we have to calibrate the system for utilization of the whole available frequency range of the multichannel frequency response analyzer up to approximately 60 kHz, to get more information above modulation frequencies above 10 kHz, This work is currently carried out.

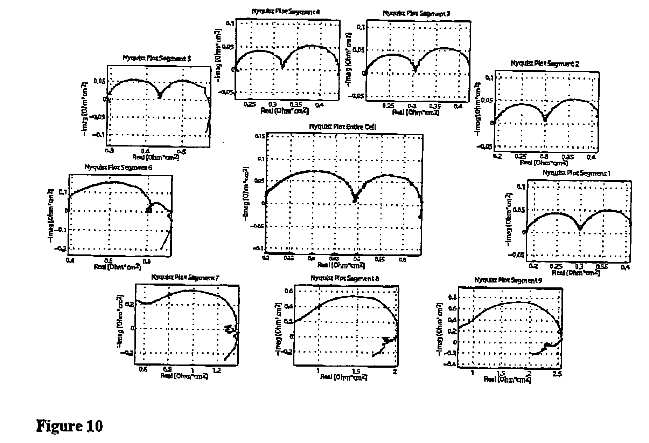

The results obtained with our setup for fast parallel locally resolved EIS in PEFCs show large differences in the local cell impedance spectra, These inhomogeneities in local cell impedance are not apparent in the impedance spectrum of the entire cell which shows only average values of the local cell impedances. The spectrum of the entire cell can be calculated from the individual spectra, since the segmented PEFC, in principle, is a parallel circuit of individual sub-cells. This has been done for the locally resolved impedance spectrum shown in figure 7b, The evolution of the spectra along the channels from the gas outlet (segment 1) to the gas inlet (segment 9) and the calculated spectrum of the entire cell are shown in figure 10.

The calculated spectrum of the entire cell is showing in principle two capacitive arcs, i.e. it is similar in shape to the impedance spectra of segments 1 - 4, although the high frequency resistance and the diameter of the high and low frequency capacitive loop are larger than in any of the impedance spectra of segments 1-4. However, the spectrum of the entire cell is different from the spectra of segments 6 - 9. For a given frequency the low impedance of the well performing segments 1 - 4 masks the high impedance of segments 6 - 9. The result of an impedance measurement across the entire active area of the cell is misleading, since the main loss in cell performance occurs due to drying of segments 6-9.

Our results clearly show that EIS performed across the entire active area of a PEFC is exceptionally meaningful if the local conditions, i.e. the local cell impedances are virtually homogeneous throughout the cell. Otherwise the impedance spectrum of the entire cell provides only limited insight into factors limiting cell performance. One has to be aware of this when performing measurements of the entire impedance of a PEFC .

### H₂/Air Operation of the Cell

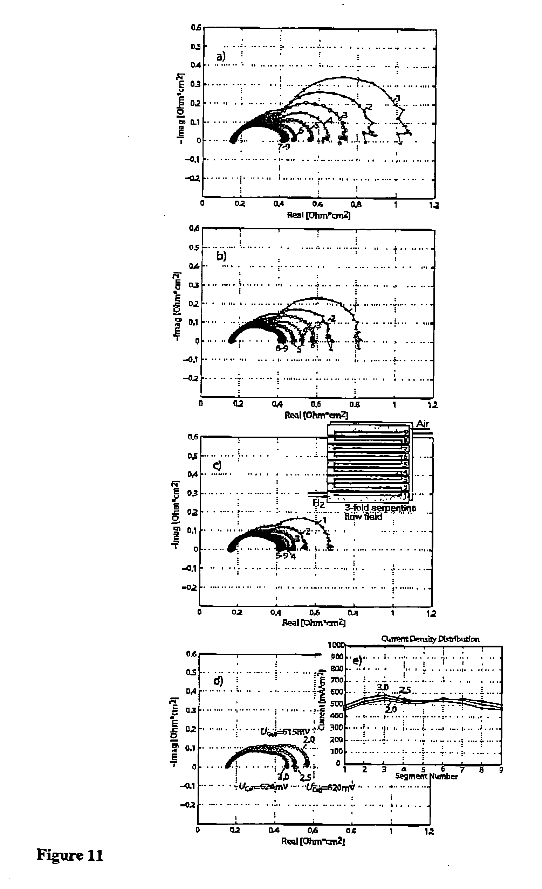

The results for H₂/air operation at different air stoichiometries are shown in figure 11. The higher frequency part of the spectrum has been attributed to processes occuring in the cathode catalyst layer, i.e. charge transfer, agglomerate and thin film diffusion. The lower frequency part of the spectrum has been assigned to mass transport limitations in the backing layer of the cathode. This model can be used to comment the spectra shown in figure 11a-d in a first approach, excluding anode limitations.

Due to the fully humidified conditions applied here, the high frequency resistance, i.e. the ohmic resistance of the segments is virtually equal at a given air stoichiometry, though at higher air stoichiometry (A= 3.0) slight differences occur, probably due to imperfect humidification of the air at higher gas flow rates.

However, the most significant characteristic of the locally resolved impedance spectra is the increasing size of the low frequency loop as a function of channel length at a given air stoichiometry from the air inlet to the outlet, as oxygen is cumulative depleted and water is cumulative formed on the cathode side along the gas channels.

In our experiments we have varied the air stoichiometry. The corresponding locally resolved impedance spectra (figure 11 a-c) show that the increasing size of the low frequency loop along the channels becomes stronger pronounced with decreasing air stoichiometry λ_{Air}. This proves the assumption that the increase of the lower frequency arc along the channels can be attributed to an increasing gas phase mass transport limitation at the air cathode. This is likely due to cumulative flooding of the GDL and a decreasing molar fraction of oxygen in the cathodic gas stream, since the increase of the lower frequency loop becomes more pronounced with decreasing air stoichiometry. Detailed investigations to prove these assumptions are currently carried out by using a combination of fast locally resolved EIS and neutron imaging of water. However, the respective calculated impedance spectra of the entire cell are only little affected by the air stoichiometry (Fig. 11 d).

### 5. Conclusions and Outlook

The system for performing fast parallel locally resolved electrochemical impedance spectroscopy described in this paper has been proven to be a powerful *in situ* diagnostic tool for PEFCs.

The high performance of the system due to our unique fast parallel approach and the high quality of the local impedance measurement has been demonstrated in a large frequency range from 10 kHz down to low frequencies of 10 mHz. For the first time parallel locally resolved EIS has been performed in a realistic PEFC operated on pure H₂/O₂ and H₂/Air.

The results show large differences in the local cell impedance spectra, i.e. regional distinctions in the processes limiting local cell performance do occur. For low humidity H₂/O₂ operation of the cell the locally resolved impedance spectra dearly show that the performance loss along the serpentine flow-field channels can be attributed to drying effects. Furthermore, with decreasing humidity an inductive behaviour is observed in the low frequency range of the spectra. For H₂/Air operation an increasing size of the lower frequency loop of the local impedance spectra along the channels from the air inlet to the outlet has been observed. This effect becomes stronger pronounced with decreasing air stoichiometry and thus is likely due to cumulative flooding of the GDL and a decreasing molar fraction of oxygen in the cathodic gas stream along the channels.

The result of an impedance measurement performed across the entire active area of a PEFC can be misleading. Our results clearly show that EIS performed across the entire active area of a PEFC is exceptionally meaningful if the local conditions, i.e. the local cell impedances are virtually homogeneous throughout the cell. Otherwise the impedance spectrum of the entire cell provides only limited insight into factors limiting cell performance. One has to be aware of this when performing impedance measurements in entire PEFCs.

The combination of locally resolved current density measurements and locally resolved electrochemical impedance spectroscopy is a powerful tool for *in situ* diagnostics in PEFCs which allows the identification and particularly the explanation of local inhomogeneities in the performance of a PEFC.

However, for an in-depth understanding of the local cell impedance spectra it is desirable to separate anode and cathode contributions to the overall segment impedances. We have successfully demonstrated a pseudo reference concept to be implemented in PEFCs for performing this task.

The highly meaningful method described in this paper will be even more powerful in combination with other advanced spatially resolved techniques, in particular in combination with simultaneous *in situ* neutron imaging of water in PEFCs. We are currently examining this combination.

This level of spatially resolved in situ diagnostics is needed to gain a deeper understanding of fuel cell operation on a local scale and to provide the detailed information needed for validating computational fuel cell modelling results.

### Figure Captions

Figure 1: Block diagram of the system for fast parallel EIS in PEFCs, employing a 9-fold segmented cell.
Figure 2: Segmented 29.2 cm² PEFC employed for the locally resolved EIS measurements.
Figure 3: a) segmented cathode flow field plate, gold plated segmented current collector and stainless steel endplate b) schematic of segmented flow field and numbering of segments c) manufacturing steps for segmented flow field plate.
Figure 4: a) schematic representation of a two-fold segmented PEFC with current measuring circuitry and b) equivalent circuit, *U*: sub-cell with impedance *Z*ᵢ, *Z*_{CCG}: impedance of the contact between current collector plate and graphite segment, *Z*_{CC}: impedance of the current collector plate, *Z*_{CD}: impedance of current drain, *Z*_{CM}: impedance of current measuring circuit
Figure 5: Simplified block diagram of the multichannel frequency response analyzer and measurement of segment voltages and segment currents.
Figure 6: Software interface for performing locally resolved EIS in PEFCs a) user interface b) Nyquist representation of segment impedance spectra in real time during the measurement.
Figure 7: a) Current density distribution curve and ohmic voltage drop Δ*U*_{IR}, b) locally resolved impedance spectrum (segment 1-9), c) locally resolved impedance spectrum (segment 1 - 4) for H₂/O₂ operation of the PEFC, Operating conditions: cell current *I*_{Cell} = 14.6 A, gas stoichiometry λ= 1.5, modulation frequency range f= 15 mHz- 10 kHz, cell voltage *U*_{Cell} = 538 mV. Numbers denote the segment number.
Figure S: a) Current density distribution curve and ohmic voltage drop Δ*U*_{IR}, b) locally resolved impedance spectrum (segments 1 - 9), c) locally resolved impedance spectrum (segments 1 - 4) for H₂/O₂ operation of the PEFC. Operating conditions: cell current *I*_{Cell}= 5 A, stoichiometry □= 4.4, modulation frequency range *f*= 10 mHz - 10 kHz, cell voltage *U*_{Cell}= 640 mV. Numbers denote the segment number.
Figure 9: Magnified representation of the high frequency range (*f*ₘₐₓ =10 kHz) of the local impedance spectra of segments 5 - 9 for H₂/O₂ operation of the cell at a cell current of *I*_{Cell} = 5 A and a gas stoichiometry of λ= 4.4. Numbers denote the segment number.
Figure 10: Evolution of local impedance spectra along the gas channels from the gas outlets (segment 1) to the gas inlets (segment 9) and calculated spectra of the entire cell for H₂/O₂ operation. Operating conditions: cell current *I*_{Cell} = 14.6 A, gas stoichiometry□= 1.5, modulation frequency range f=15 mHz-10 kHz, cell voltage *U*_{Cell} = 538 mV. Numbers denote the segment number.
Figure 11: a-c) Locally resolved impedance spectra for H₂/air operation of the PEFC at air stoichiometries of a) λₐᵢᵣ = 2.0, b) λₐᵢᵣ = 2.5 and c) λₐᵢᵣ = 3.0. Numbers denote the segment number. d) Calculated spectra of the entire cell and average cell voltage at air stoichiometries of λₐᵢᵣ = 2.0, λₐᵢᵣ = 2.5 and λₐᵢᵣ = 3.0. e) Current density distribution curves at air stoichiometries of λₐᵢᵣ = 2.0, λₐᵢᵣ = 2.5 and λₐᵢᵣ = 3.0. Modulation frequency range f= 100 mHz - 10 kHz.

## Claims

1. A membrane electrode assembly, comprising:
a sandwich comprising an electrode layer, an ion conducting membrane and
again an electrode layer, thereby at least one of the electrode layer is electrically separated in rows, each row being separately connected to an electronic drive and analysis device.

2. A membrane electrode assembly, comprising:
a sandwich comprising a bipolar plate with an electrode layer, an ion conducting membrane and again a bipolar plate with an electrode layer, thereby at least one of the bipolar plate is electrically separated in rows, each row being separately connected to an electronic drive and analysis circuitry.
